# EUROPEAN PATENT APPLICATION

(11) **EP 4 780 167 A1**
(43) Date of publication of application: **22.07.2026**
(21) Application number: 25843279.8
(22) Date of filing: 11.04.2025
(51) Int. Cl.: H10F 10/10

(54) **SOLAR CELL, TOPCON CELL, PHOTOVOLTAIC MODULE, AND TANDEM CELL**

(30) Priority: 22.07.2024 CN 202421740101 U
(71) Applicant: Zhejiang Aiko Solar Energy Technology Co., Ltd., Yiwu, Jinhua Zhejiang 322000 (CN); Guangdong Aiko Solar Energy Technology Co., Ltd., Foshan, Guangdong 528000 (CN); Tianjin Aiko Solar Energy Technology Co., Ltd., Tianjin 300400 (CN); Zhuhai Fushan Aiko Solar Energy Technology Co., Ltd., FushanIndustrial Park, Doumen District Zhuhai Guangdong 519000 (CN); Chuzhou Aiko Solar Technology Co., Ltd., Chuzhou, Anhui 239514 (CN)
(72) Inventor: LI, Maohong, Jinhua, Zhejiang 322000 (CN); ZHANG, Shengli, Jinhua, Zhejiang 322000 (CN); CHEN, Hui, Jinhua, Zhejiang 322000 (CN); CHEN, Gang, Jinhua, Zhejiang 322000 (CN)
(74) Representative: EP&C
(86) International application number: PCT/CN2025/088621
(87) International publication number: WO 2026/020887

(57) **Abstract**

The present disclosure is applicable to the technical field of solar power generation. Provided are a solar cell, a TOPCon cell, a photovoltaic module and a tandem cell; the solar cell comprises a silicon substrate, the silicon substrate having a front side and a rear side opposite each other; the front side of the silicon substrate is provided with a first textured surface; a preset range area at the edge of the front side of the silicon substrate is provided with a second textured surface; the first textured surface has a pyramid structure; the second textured surface has a rounded-top pyramid structure; and the rounded-top pyramid structure has a cambered surface. By the described arrangement, the first textured surface having the pyramid structure is formed on the front side of the silicon substrate, and the second textured surface having the rounded-top pyramid structure is formed on the basis of the first textured surface by secondary etching, thereby reducing the doping concentration on the front side of the silicon substrate, reducing the surface recombination on the front side of the silicon substrate, increasing the open-circuit voltage and the current, and improving the conversion efficiency.

## Description

### Cross-Reference to Related Application

The present disclosure claims the priority of Chinese Patent Application no. 202421740101.8, filed to the China National Intellectual Property Administration on 22 July 2024 and entitled "Solar Cell, TOPCon Cell, Photovoltaic Module and Tandem Cell", the disclosure of which is incorporated herein by reference in its entirety.

### Technical Field

The present disclosure relates to the technical field of solar power generation, and in particular, to a solar cell, a TOPCon cell, a photovoltaic module, and a tandem cell.

### Background

A solar cell, which is a photoelectric semiconductor sheet directly generating electricity using sunlight, is also referred to as a "solar chip" or "photovoltaic cell". As long as the illuminance thereof satisfies a certain illumination condition, the solar cell can output a voltage instantly and generate a current in the case of a circuit.

In the production of solar cells, the performance and photoelectric conversion efficiency of silicon wafer solar cells are closely related to the surface structure of the solar cell. Therefore, during the manufacturing process, performing chemical etching texturing on the silicon wafer is a critical process. This process aims to reduce the surface reflectivity of the silicon wafer, increase light absorption, and enhance the density of photogenerated carriers, thereby improving the photoelectric conversion efficiency of the solar cell. However, the front side of existing solar cells has a high doping concentration, leading to high recombination at the front side, which affects the conversion efficiency of the solar cell.

### Summary

Embodiments of the present disclosure provide a solar cell, which is intended to solve the problem that the conversion efficiency of a solar cell is affected due to high recombination of the front side of existing solar cells.

Embodiments of the present disclosure are implemented as follows: a solar cell, including a silicon substrate, the silicon substrate having a front side and a rear side opposite each other, wherein the front side of the silicon substrate is provided with a first textured surface; a preset range area at the edge of the front side of the silicon substrate is provided with a second textured surface; the first textured surface has a pyramid structure; the second textured surface has a rounded-top pyramid structure; and a tip of the rounded-top pyramid structure has a cambered surface.

In some embodiments, the preset range area is an area less than or equal to 20 millimeters distant from an edge of the silicon substrate.

In some embodiments, the preset range area is an area less than or equal to 5 millimeters distant from an edge of the silicon substrate.

In some embodiments, the silicon substrate includes any one of a P-type silicon wafer and an N-type silicon wafer.

In a second aspect, the present disclosure further provides a TOPCon cell, including the described solar cell.

In some embodiments, the TOPCon cell includes an emitter layer, a silicon substrate, a diffused doping layer, a silicon oxide layer, a doped polysilicon layer, a front electrode and a rear electrode; the emitter layer is provided on the front side of the silicon substrate; the front electrode is connected to the emitter layer; the diffused doping layer, the silicon oxide layer and the doped polysilicon layer are sequentially arranged on the rear side of the silicon substrate in the direction extending away from the silicon substrate; and the rear electrode is connected to the doped polysilicon layer.

In some embodiments, the silicon oxide layer and the doped polysilicon layer are provided in a partial area of the rear side of the silicon substrate.

In some embodiments, a front passivation film is provided on the side of the emitter layer away from the silicon substrate, and a rear passivation film is provided on the side of the doped polysilicon layer away from the silicon substrate.

In some embodiments, the front passivation film and the rear passivation film include at least one of silicon nitride, aluminum oxide, silicon oxynitride and silicon oxide.

In a third aspect, the present disclosure further provides a photovoltaic module, including the described TOPCon cell.

In a fourth aspect, the present disclosure further provides a tandem cell, including a perovskite cell and the described TOPCon cell.

The beneficial effect of the present disclosure lies in that the solar cell of the present disclosure includes a silicon substrate, the silicon substrate having a front side and a rear side opposite each other, wherein the front side of the silicon substrate is provided with a first textured surface; a preset range area at the edge of the front side of the silicon substrate is provided with a second textured surface; the first textured surface has a pyramid structure; the second textured surface has a rounded-top pyramid structure; and the rounded-top pyramid structure has a cambered surface. By the described arrangement, the first textured surface having the pyramid structure is formed on the front side of the silicon substrate, and secondary etching is performed on the basis of the first textured surface, so that the pyramid tip of the rounded-top pyramid structure has a cambered surface, so as to form the second textured surface having the rounded-top pyramid structure, thereby reducing the doping concentration on the front side of the silicon substrate, reducing the surface recombination on the front side of the silicon substrate, increasing the open-circuit voltage and the current, and improving the conversion efficiency.

### Brief Description of the Drawings

Fig. 1 is a schematic structural diagram of an embodiment of a solar cell according to the present disclosure;
Fig. 2 is a schematic structural diagram of a first textured surface of an embodiment of a solar cell according to the present disclosure;
Fig. 3 is a schematic structural diagram of a second textured surface of an embodiment of a solar cell according to the present disclosure;
Fig. 4 is a schematic structural diagram of one embodiment of a TOPCon cell according to the present disclosure.

### Detailed Description of the Embodiments

To make the objectives, technical solutions, and advantages of the present disclosure clearer, the present disclosure is further described in details below in combination with the drawings and embodiments. Examples of the embodiments will be illustrated in the accompanying drawings, wherein throughout the description, same or similar reference numerals represent same or similar elements or elements with same or similar functions. The embodiments described below with reference to the accompanying drawings are illustrative, and are intended to illustrate the present disclosure, and shall not be understood as limiting the present disclosure. In addition, it should be understood that the specific embodiments described herein are only used to explain the present disclosure, and are not intended to limit the present disclosure.

In the description of the present disclosure, it should be understood that, orientations or position relationships indicated by terms such as "length", "width", "upper", "lower", "left", "right", "horizontal", "top", "bottom" and the like are orientations or position relationships based on accompanying drawings and are only for the convenience of illustration of the specification and simplicity of illustration, rather than explicitly or implicitly indicate that apparatuses or components referred to herein must have a certain direction or be configured or operated in a certain direction and therefore cannot be understood as limitations to the present disclosure.

In addition, the terms "first" and "second" are only used for descriptive purposes, and cannot be understood as indicating or implying relative importance or implicitly indicating the number of indicated technical features. Thus, features defined by "first" and "second" can explicitly or implicitly include one or more of the features. In the description of the present disclosure, "a plurality of" refers to two or more than two, unless specified otherwise.

In the description of the present disclosure, it should be noted that, unless otherwise specified or defined, the terms such as "mount", "connected" and "connection" should be understood in a broad sense, for example, the connection can be a permanent connection, or a detachable connection, or an integral connection; can be a mechanical connection, can also be an electrical connection or can be an intercommunication; and can be a direct connection, an indirect connection through a medium, or a communication connection between two components or an interaction connection between two components. For those of ordinary skill in the art, the specific meanings of the above terms in the present disclosure can be understood according to specific situations.

In the present disclosure, unless specified or limited otherwise, a first feature being "above" or "below" a second feature can include a direct contact between the first feature and the second feature, and can also include another feature contact between the first feature and the second feature rather than a direct contact. In addition, the first feature being "above", "over", and "on" the second feature includes the first feature being right above and obliquely above the second feature or only refers to the first feature being at a higher horizontal level than the second feature. The first feature being "below", "underneath", and "under" the second feature includes the first feature being right below and obliquely below the second feature or only refers to the first feature being at a lower horizontal level than the second feature.

The following disclosure provides many different embodiments or examples for implementing different structures of the present disclosure. In order to simplify the disclosure of the present disclosure, components and settings of specific examples are described below. Of course, they are merely examples and are not intended to limit the present disclosure. In addition, the present disclosure can repeat at least one of the following: reference numerals and reference letters in different examples. This repetition is for the purpose of simplicity and clarity, and does not in itself indicate a relationship between at least one of the discussed below: the various embodiments and arrangements. In addition, the present disclosure provides examples of various specific processes and materials, but those skilled in the art will recognize at least one of the following: the application of other processes and the use of other materials.

The solar cell of the present disclosure includes a silicon substrate, the silicon substrate having a front side and a rear side opposite each other, wherein the front side of the silicon substrate is provided with a first textured surface; a preset range area at the edge of the front side of the silicon substrate is provided with a second textured surface; the first textured surface has a pyramid structure (it can be understood that, the tip of the pyramid structure is conical, the pyramid tip is sharp); the second textured surface has a rounded-top pyramid structure; and the rounded-top pyramid structure has a cambered surface. By the described arrangement, the first textured surface having the pyramid structure is formed on the front side of the silicon substrate, and secondary etching is performed on the basis of the first textured surface, so that the top of the tip of the rounded-top pyramid structure has a cambered surface, so as to form the second textured surface having the rounded-top pyramid structure, thereby reducing the doping concentration on the front side of the silicon substrate, reducing the surface recombination on the front side of the silicon substrate, increasing the open-circuit voltage and the current, and improving the conversion efficiency. It can be understood that, both the pyramid structure and the rounded-top pyramid structure are mini-pyramid structures.

### Embodiment I

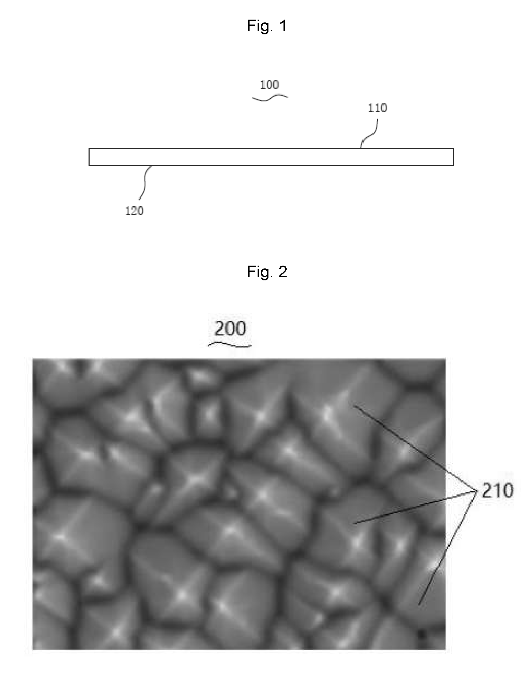

As shown in Fig. 1 to Fig. 4, one embodiment of the present disclosure provides a solar cell, including a silicon substrate 100, the silicon substrate 100 having a front side 110 and a rear side 120 opposite each other, wherein the front side 110 of the silicon substrate 100 is provided with a first textured surface 200; a preset range area at the edge of the front side 110 of the silicon substrate 100 is provided with a second textured surface 300; the first textured surface 200 has a pyramid structure 210; the second textured surface 300 has a rounded-top pyramid structure 310; and the rounded-top pyramid structure 310 has a cambered surface.

During implementation, the silicon substrate 100 is a silicon wafer, and the silicon substrate 100 can be a P-type silicon wafer or an N-type silicon wafer, which is not limited herein.

During implementation, there is no essential difference in the power generation principle of solar cells using P-type silicon wafers or N-type silicon wafers, as both rely on the PN junction for the separation of photogenerated carriers.

Optionally, by doping the semiconductor with donor impurities (such as phosphorus or other pentavalent elements), an N-type semiconductor material is obtained; and by doping the semiconductor with acceptor impurities (such as boron or other trivalent elements), a P-type semiconductor material is obtained.

A solar cell of a n+/p type structure, which is formed by diffusing a pentavalent element, such as phosphorus, into a P-type semiconductor material, is a P-type cell; and a solar cell of a p+/n type structure, which is formed by injecting a trivalent element, such as boron, into an N-type semiconductor material, is an N-type cell.

The silicon substrate 100 is in the form of a sheet or a plate, and has a front side 110 and a rear side 120 opposite to each other. Generally, the front side 110 of the silicon substrate 100 can be regarded as a light receiving surface of the solar cell, and likewise, the rear side 120 of the silicon substrate 100 can be regarded as a backlight surface of the solar cell.

The front side 110 of the silicon substrate 100 is provided with a first textured surface 200; the first textured surface 200 is obtained by chemical etching texturing; the principle is that silicon wafers (the silicon substrate 100) of different crystal planes or directions are etched at different corrosion rates in a chemical solution by using anisotropy or isotropy of the silicon crystal, so that textured structures of different shapes and sizes are formed on the surface of the silicon wafers; and the textured structure is a pyramid structure 210, as shown in Fig. 2.

During implementation, the textured structure can increase the roughness of the surface of the silicon wafer, reduce the reflection of light, increase the absorption of light, change the incidence angle and propagation path of light, form a light trap, increase the density of photogenerated carriers, and thus increase the photoelectric conversion rate of the cell.

Chemical etching texturing of the silicon substrate 100 can be performed by alkaline texturing or acidic texturing. Alkaline texturing uses alkaline solutions, such as sodium hydroxide, potassium hydroxide, or tetramethylammonium hydroxide, to perform anisotropic etching on the silicon wafer, which is mainly applicable to monocrystalline silicon wafers. Acid texturing uses an acidic solution, such as an acetic acid solution or an aqueous solution of nitric acid and hydrofluoric acid, to perform isotropic etching on the silicon wafer, which is mainly applicable to polycrystalline silicon wafers.

In some possible embodiments, the rear side 120 of the silicon substrate 100 can also be provided with the first textured surface 200, which can further improve the photoelectric conversion rate of the solar cell, and will not be repeated here.

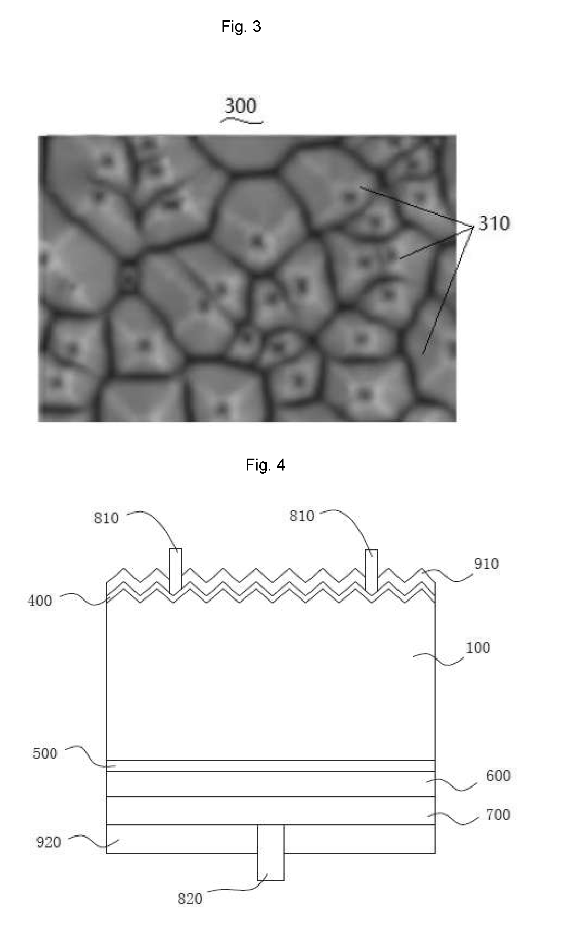

After preparing the first textured surface 200 on the front side 110 of the silicon substrate 100, a second textured surface 300 can be further prepared at a preset range area at the edge of the front side 110 of the silicon substrate 100, that is, secondary etching is performed on the first textured surface 200 of the silicon substrate 100 in the preset range area at the edge of the front side 110 to form the second textured surface 300, in this way, the tip of the pyramid structure 210 at the preset range area at the edge of the front side 110 is corroded to obtain the rounded-top pyramid structure 310, and the top of the tip of the rounded-top pyramid structure 310 has a cambered surface, as shown in Fig. 3.

Optionally, the preset range area is an area less than or equal to 20 millimeters distant from an edge of the silicon substrate 100, for example, 10 millimeters, 12 millimeters, 15 millimeters or 18 millimeters, which is not limited herein. Further, the preset range area is an area less than or equal to 5 millimeters distant from an edge of the silicon substrate, for example, 1 millimeter, 2 millimeters, 3 millimeters, or 4 millimeters, which is not limited herein.

During implementation, the side surface of the silicon substrate 100 (the side surface is located between the front side 110 and the rear side 120 of the silicon substrate 100) can be immersed in the etching solution, so that the edge portion of the silicon substrate 100 is also immersed in the etching solution (for example, the alkaline solution or the acidic solution) to etch the tip of the pyramid.

In some possible embodiments, if only the second textured surface 300 needs to be prepared on the front side 110 of the silicon substrate 100, before the secondary etching, the side surface and the rear side 120 of the silicon substrate 100 can be covered with a layer of water film to protect the side surface and the rear side 120 of the silicon substrate 100, so as to prevent the side surface and the rear side 120 of the silicon substrate 100 from being affected by the secondary etching.

The solar cell of the present disclosure includes a silicon substrate 100, the silicon substrate 100 having a front side 110 and a rear side 120 opposite each other, wherein the front side 110 of the silicon substrate 100 is provided with a first textured surface 200; a preset range area at the edge of the front side 110 of the silicon substrate 100 is provided with a second textured surface 300; the first textured surface 200 has a pyramid structure 210; the second textured surface 300 has a rounded-top pyramid structure 310; and the rounded-top pyramid structure 310 has a cambered surface. By the described arrangement, the first textured surface 200 having the pyramid structure 210 is formed on the front side 110 of the silicon substrate 100, and secondary etching is performed on the basis of the first textured surface 200, so that the top of the tip of the rounded-top pyramid structure 310 has a cambered surface, so as to form the second textured surface 300 having the rounded-top pyramid structure 310, thereby reducing the doping concentration on the front side 110 of the silicon substrate 100, reducing the surface recombination on the front side 110 of the silicon substrate 100, increasing the open-circuit voltage and the current, and improving the conversion efficiency.

### Embodiment II

In some optional embodiments, the present disclosure further provides a TOPCon cell, including the described solar cell. TOPCon is the abbreviation for Tunnel Oxide Passivated Contact, i.e. an oxide passivated contact cell.

Optionally, the TOPCon cell provided in the present disclosure refers to a single-sided TOPCon cell, that is, a passivated contact structure consisting of a layer of ultra-thin silicon oxide (1 nm to 2 nm) and a layer of doped polysilicon film is provided on the rear side 120 of the cell.

A person skilled in the art would have been able to clearly understand that, for the purpose of convenient and brief description, for the structure and implementation principle of the TOPCon cell that are described above, reference can be made to the corresponding structure and implementation principle in Embodiment I, and details are not described herein again.

The solar cell of the present disclosure includes a silicon substrate 100, the silicon substrate 100 having a front side 110 and a rear side 120 opposite each other, wherein the front side 110 of the silicon substrate 100 is provided with a first textured surface 200; a preset range area at the edge of the front side 110 of the silicon substrate 100 is provided with a second textured surface 300; the first textured surface 200 has a pyramid structure 210; the second textured surface 300 has a rounded-top pyramid structure 310; and the rounded-top pyramid structure 310 has a cambered surface. By the described arrangement, the first textured surface 200 having the pyramid structure 210 is formed on the front side 110 of the silicon substrate 100, and secondary etching is performed on the basis of the first textured surface 200, so that the top of the tip of the rounded-top pyramid structure 310 has a cambered surface, so as to form the second textured surface 300 having the rounded-top pyramid structure 310, thereby reducing the doping concentration on the front side 110 of the silicon substrate 100, reducing the surface recombination on the front side 110 of the silicon substrate 100, increasing the open-circuit voltage and the current, and improving the conversion efficiency.

In some optional embodiments, the present disclosure provides a TOPcon cell, including an emitter layer 400, a silicon substrate 100, a diffused doping layer 500, a silicon oxide layer 600, a doped polysilicon layer 700, a front electrode 810 and a rear electrode 820; the emitter layer 400 is provided on the front side 110 of the silicon substrate 100; the front electrode 810 is connected to the emitter layer 400; the diffused doping layer 500, the silicon oxide layer 600 and the doped polysilicon layer 700 are sequentially arranged on the rear side 120 of the silicon substrate 100 along the direction extending away from the silicon substrate 100; and the rear electrode 820 is connected to the doped polysilicon layer 700.

During implementation, the solar cell provided in Embodiment I can be regarded as a silicon substrate of a TOPcon cell, wherein the front side 110 of the silicon substrate 100 corresponds to a front side of the TOPcon cell, and the rear side 120 of the silicon substrate 100 corresponds to a rear side of the TOPcon cell.

The front side 110 of the solar cell is provided with an emitter layer 400; the rear side 120 of the solar cell is provided with a diffused doping layer 500; and the emitter layer 400 and the diffused doping layer 500 refer to doped layers formed by further doping on the basis of the silicon substrate 100. Exemplarily, for example, the silicon substrate 100 is an N-type silicon wafer, boron can be doped into the front side 110 of the silicon substrate 100 to form the emitter layer 400, and in this case, the emitter layer 400 can be regarded as a p+ layer, and phosphorus is doped into the rear side 120 of the silicon substrate to obtain the diffused doping layer 500; the diffused doping layer 500 can be formed either by separate diffusion or by diffusion from the doped polysilicon layer 700 into the silicon substrate 100.

By providing the passivated contact structure on the rear side 120 of the cell, the recombination of minority carriers (holes) can be blocked, thereby enhancing the open-circuit voltage and short-circuit current of the cell. The ultra-thin silicon oxide layer 600 can enable majority carriers (electrons) to tunnel into the doped polysilicon layer 700 while blocking the recombination of minority carriers (holes); the excellent passivation effect of the ultra-thin silicon oxide layer 600 and the doped polysilicon layer 700 enables the surface energy band of the silicon wafer to be bent, thereby forming a field passivation effect, greatly increasing the probability of electron tunneling, reducing the contact resistance, and improving the open-circuit voltage and short-circuit current of a cell, thereby improving the conversion efficiency of the cell.

In some possible embodiments, the diffused doping layer 500 is provided in the partial area of the rear side 120 of the silicon substrate 100, that is to say, the diffused doping layer 500 is in partial contact with the solar cell, and the surface recombination of non-contact areas is reduced.

In some possible embodiments, the silicon oxide layer 600 and the doped polysilicon layer 700 are provided in the partial area of the rear side of the silicon substrate 100, that is to say, the silicon oxide layer 600 and the silicon substrate 100 are in partial contact with each other, which can effectively reduce contact recombination.

In some possible embodiments, a front passivation film 910 is provided on the side of the emitter layer 400 away from the silicon substrate 100, and a rear passivation film 920 is provided on the side of the doped polysilicon layer 700 away from the silicon substrate 100.

The front passivation film 910 and the rear passivation film 920 are both passivation and anti-reflection films; the passivation and anti-reflection film is configured to improve the photoelectric conversion efficiency and stability of the solar cell, reducing the surface damage and oxidation reaction of the solar cell, and prolonging the service life of the solar cell.

In practice, the front electrode 810 is connected to the emitter layer 400 after passing through the front passivation film 910, and the rear electrode 820 is connected to the doped polysilicon layer 700 after passing through the rear passivation film 920.

In some embodiments, the rear electrode 820 connected to the doped polysilicon layer 700 can be in contact with the surface of the doped polysilicon layer 700. In other optional embodiments, the rear electrode 820 is formed by casting a molten metal paste onto the doped polysilicon layer 700 and then cooling, and some metal crystals of the metal paste penetrate into the doped polysilicon layer 700, that is, a metal electrode is in contact with the doped polysilicon layer 700, and some metal crystals are formed in the doped polysilicon layer 700. By the described arrangement, metal crystals facilitate the movement of carriers to the metal electrode, thereby improving the efficiency of the solar cell.

Optionally, the front passivation film 910 and the rear passivation film 920 include at least one of silicon nitride, aluminum oxide, silicon oxynitride and silicon oxide, which is not limited herein. Preferably, at least one of the front passivation film 910 and the rear passivation film 920 can be made of aluminum oxide, so as to ensure the light absorption rate.

### Embodiment III

In some optional embodiments, the present disclosure provides a photovoltaic module that includes a TOPCon cell as described above.

A person skilled in the art would have been able to clearly understand that, for the purpose of convenient and brief description, for the structure and implementation principle of the photovoltaic module that are described above, reference can be made to the corresponding structure and implementation principle in Embodiments I and II, and details are not described herein again.

The solar cell of the present disclosure includes a silicon substrate 100, the silicon substrate 100 having a front side 110 and a rear side 120 opposite each other, wherein the front side 110 of the silicon substrate 100 is provided with a first textured surface 200; a preset range area at the edge of the front side 110 of the silicon substrate 100 is provided with a second textured surface 300; the first textured surface 200 has a pyramid structure 210; the second textured surface 300 has a rounded-top pyramid structure 310; and the rounded-top pyramid structure 310 has a cambered surface. By the described arrangement, the first textured surface 200 having the pyramid structure 210 is formed on the front side 110 of the silicon substrate 100, and secondary etching is performed on the basis of the first textured surface 200, so that the top of the tip of the rounded-top pyramid structure 310 has a cambered surface, so as to form the second textured surface 300 having the rounded-top pyramid structure 310, thereby reducing the doping concentration on the front side 110 of the silicon substrate 100, reducing the surface recombination on the front side 110 of the silicon substrate 100, increasing the open-circuit voltage and the current, and improving the conversion efficiency.

### Embodiment IV

In a fourth aspect, the present disclosure further provides a tandem cell, including a perovskite cell and the described TOPCon cell.

In practice, perovskite cells are perovskite solar cells, and are solar cells that utilize organometal halide perovskite semiconductors as light-absorbing materials. The tandem solar cell provided in the present disclosure is a perovskite-silicon tandem solar cell; the perovskite-silicon tandem solar cell uses the wide bandgap structural characteristics of perovskite materials; by placing the perovskite materials above the silicon cell, it can absorb high-energy photons in the short-wavelength range that are difficult for the silicon cell to absorb, thereby maximizing the utilization of incident light and improving the conversion efficiency of the photovoltaic cell. Additionally, it also provides a higher theoretical efficiency limit, which will not be described further.

A person skilled in the art would have been able to clearly understand that, for the purpose of convenient and brief description, for the structure and implementation principle of the tandem cell that are described above, reference can be made to the corresponding structure and implementation principle in Embodiments I to III, and details are not described herein again.

The solar cell of the present disclosure includes a silicon substrate 100, the silicon substrate 100 having a front side 110 and a rear side 120 opposite each other, wherein the front side 110 of the silicon substrate 100 is provided with a first textured surface 200; a preset range area at the edge of the front side 110 of the silicon substrate 100 is provided with a second textured surface 300; the first textured surface 200 has a pyramid structure 210; the second textured surface 300 has a rounded-top pyramid structure 310; and the rounded-top pyramid structure 310 has a cambered surface. By the described arrangement, the first textured surface 200 having the pyramid structure 210 is formed on the front side 110 of the silicon substrate 100, and secondary etching is performed on the basis of the first textured surface 200, so that the top of the tip of the rounded-top pyramid structure 310 has a cambered surface, so as to form the second textured surface 300 having the rounded-top pyramid structure 310, thereby reducing the doping concentration on the front side 110 of the silicon substrate 100, reducing the surface recombination on the front side 110 of the silicon substrate 100, increasing the open-circuit voltage and the current, and improving the conversion efficiency.

The described content merely relates to preferred embodiments of the present disclosure, and is not intended to limit the present disclosure, and any modifications, equivalent replacements, improvements, etc. made within the spirit and principle of the present disclosure shall all fall within the scope of protection of the present disclosure.

## Claims

1. A solar cell, comprising a silicon substrate, the silicon substrate having a front side and a rear side opposite each other; the front side of the silicon substrate being provided with a first textured surface; a preset range area at an edge of the front side of the silicon substrate being provided with a second textured surface; the first textured surface having a pyramid structure; the second textured surface having a rounded-top pyramid structure; and a top of a tip of the rounded-top pyramid structure having a cambered surface.

2. The solar cell according to claim 1, wherein the preset range area is an area less than or equal to 20 millimeters distant from an edge of the silicon substrate.

3. The solar cell according to claim 2, wherein the preset range area is an area less than or equal to 5 millimeters distant from the edge of the silicon substrate.

4. The solar cell according to claim 1, wherein the silicon substrate comprises any one of a P-type silicon wafer and an N-type silicon wafer.

5. A TOPCon cell, comprising the solar cell according to any one according to claims 1 to 4.

6. The TOPCon cell according to claim 5, wherein the TOPCon cell comprises an emitter layer, a silicon substrate, a diffused doping layer, a silicon oxide layer, a doped polysilicon layer, a front electrode and a rear electrode; the emitter layer is provided on the front side of the silicon substrate; the front electrode is connected to the emitter layer; the diffused doping layer, the silicon oxide layer and the doped polysilicon layer are sequentially arranged on the rear side of the silicon substrate along a direction extending away from the silicon substrate; and the rear electrode is connected to the doped polysilicon layer.

7. The TOPCon cell according to claim 6, wherein the silicon oxide layer and the doped polysilicon layer are provided in a partial area of the rear side of the silicon substrate.

8. The TOPCon cell according to claim 6, wherein a front passivation film is provided on a side of the emitter layer away from the silicon substrate, and a rear passivation film is provided on a side of the doped polysilicon layer away from the silicon substrate.

9. The TOPCon cell according to claim 8, wherein the front passivation film and the rear passivation film comprise at least one of silicon nitride, aluminum oxide, silicon oxynitride and silicon oxide.

10. A photovoltaic module comprising the TOPCon cell according to any one of claims 5 to 9.

11. A tandem cell comprising a perovskite cell and the TOPCon cell according to any one of claims 5 to 9.
